# FASCICULE DE BREVET EUROPEEN

(11) **EP 0 676 915 B1**
(45) Date de publication et mention de la délivrance du brevet: **21.10.1998**
(21) Numéro de dépôt: 95400697.9
(22) Date de dépôt: 29.03.1995
(51) Int. Cl.: H05K 7/14, H05K 9/00

(54) **Dispositif de connexion de masse pour appareil d'automatisation**
Erdungsanordnung für Automatisierungsgerät
Grounding device for automation apparatus

(30) Priorité: 06.04.1994 FR 9404134
(43) Date de publication de la demande: 11.10.1995
(73) Titulaire: Schneider Automation, 06560 Valbonne (FR)
(72) Inventeur: Malgouires, Pascal, F-06150 Cannes la Bocca (FR)
(74) Mandataire: Saint Martin, René

(56) Documents cités:
- EP-A- 0 162 373
- EP-A- 0 351 070
- US-A- 4 803 306

## Description

La présente invention concerne un appareil d'automatisation tel qu'un automate programmable modulaire comprenant un dispositif de connexion de masse, notamment de liaison de terre.

Un tel automate programmable comprend un ou plusieurs modules d'interface amovibles juxtaposés renfermant chacun, dans un boîtier, une électronique de traitement implantée sur un ou plusieurs circuits imprimés pouvant être relié électriquement à un circuit imprimé de liaison, par des connecteurs respectifs, le circuit imprimé de liaison étant porté par un support et reliant les modules entre eux et à une unité centrale de traitement. Le boîtier peut être fixé au support et relié électriquement à une partie conductrice de celui-ci par un dispositif de mise à la masse.

Lorsque le module est fixé au support, et connecté au bus de liaison, il est préférable qu'une partie conductrice du support et le module soient en contact électrique mutuel pour assurer une mise à la masse des circuits imprimés du module. Et lorsqu'un opérateur monte ou démonte le module du bus de liaison, il est souhaitable que la liaison de masse soit établie en premier ou interrompue en dernier, afin de protéger l'électronique de traitement.

Cette continuité des masses du module par rapport à l'automate, et par suite la mise à la terre de l'automate, la partie conductrice du support étant reliée à la terre, sont généralement assurées par des vis.

Les vis ont pour autre fonction la fixation du module sur le support. Or un montage du module par vissage peut être relativement long et nécessite un outil.

C'est pourquoi l'invention cherche à obtenir une facilité de montage du module sur son support, tout en visant une continuité de la liaison de masse lors de la connexion ou déconnexion des circuits du module avec le circuit imprimé de liaison.

La présente invention concerne par conséquent les raccordements de mise à la masse ou à la terre d'éléments constitutifs d'un module ou connectés à celui-ci.

Il s'agit selon l'invention d'un dispositif de mise à la masse présentant des éléments de connexion comportant un élément mâle et un élément femelle qui, coopérant par enfichage, assurent un contact électrique mutuel entre le module et le support. Le circuit imprimé de liaison comprend une ouverture traversée de manière isolée, dans la position montée du module, par l'un au moins des éléments de connexion.

Selon une caractéristique, l'élément de connexion femelle comprend une pièce métallique élastique logée dans une cavité borgne d'un nez métallique rigide.

Selon une autre caractéristique, le boîtier du module comprend une paroi arrière métallique et l'élément de connexion solidaire du module vient de moulage avec la paroi arrière du module.

Selon une autre caractéristique, l'élément de connexion solidaire du support est un doigt venant de moulage avec le support.

Selon une autre caractéristique, les distances mutuelles entre les parties actives des éléments de connexion de masse et les éléments de connexion des connecteurs sont telles que la liaison de masse soit établie en premier lors de la connexion des circuits imprimés du module au circuit imprimé de liaison et interrompue en dernier lors de leur déconnexion.

La description faite ci-après en regard des dessins fera ressortir les caractéristiques et avantages de l'invention.

Aux dessins annexés:
- la figure 1 est une perspective vue de l'arrière montrant en éclaté la platine, le circuit imprimé de liaison et les modules électroniques juxtaposés d'un automate programmable;
- la figure 2 est une perspective analogue à la figure 1 vue de l'avant;

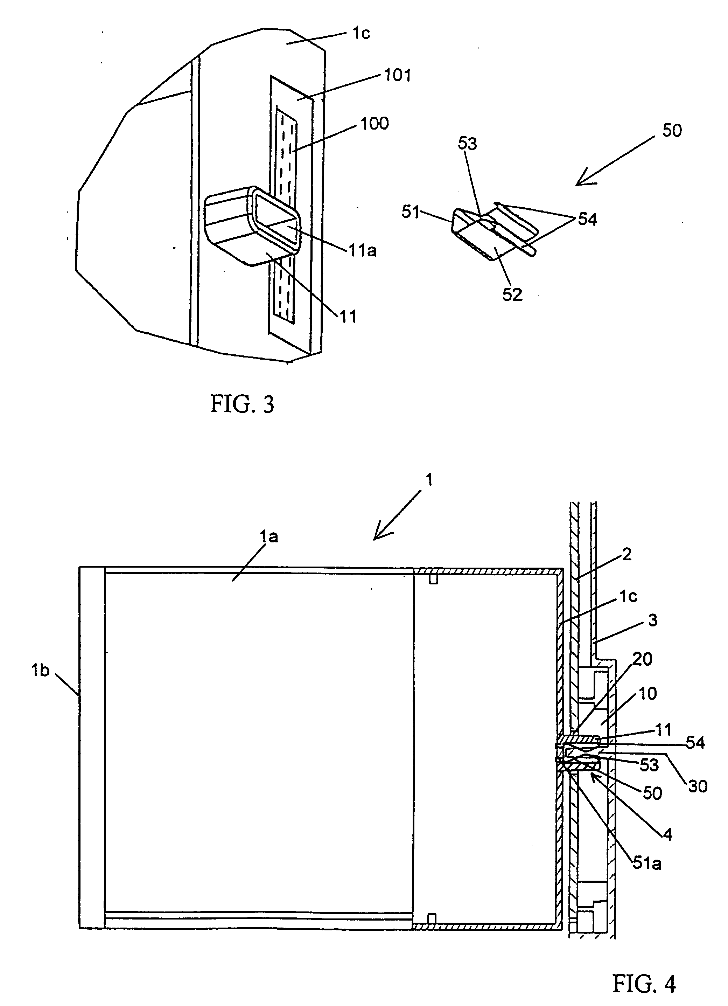

- la figure 3 est une vue partielle de la partie arrière d'un module comprenant un élément de connexion de masse et une vue de profil d'une pièce métallique associable à cet élément de connexion;
- la figure 4 est une vue partiellement en coupe du module selon un plan vertical passant par la liaison de masse;

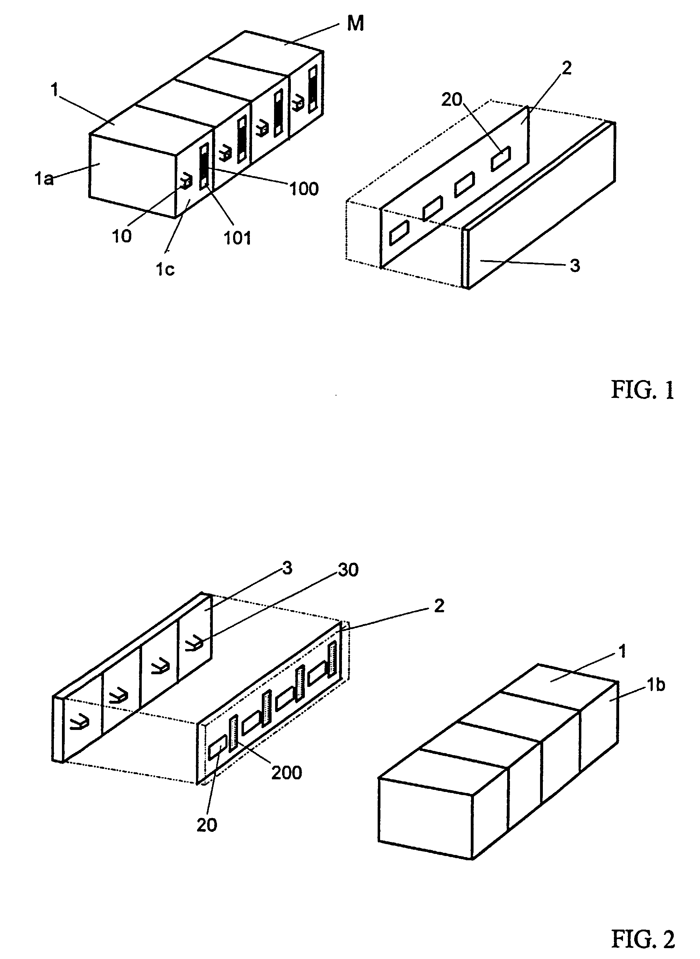

Les figures 1 et 2 montrent plusieurs modules électroniques M juxtaposés d'automate programmable.

Un module comprend un boîtier 1 à parois latérales 1a, paroi avant 1b et paroi arrière métallique 1c qu'on appellera encore embase de module. Il comprend une électronique de traitement implantée sur un circuit imprimé logé dans le boîtier.

Le circuit imprimé est relié électriquement du côté de l'embase à un circuit imprimé de liaison 2 par des connecteurs respectifs 100 et 200.

Le circuit imprimé de liaison est porté par un support 3, une platine métallique par exemple, relié à la terre. Le circuit imprimé de liaison comprend des ouvertures 20.

Un dispositif 4 de mise à la masse relie un module à la platine en traversant de manière isolée le circuit imprimé de liaison par une ouverture 20 de celui-ci. L'isolement comprend un intervalle d'air ou une couche isolante garnissant l'ouverture.

Le dispositif 4 selon l'invention comprend un élément femelle 10 et un élément mâle 30 coopérant par enfichage.

L'élément mâle 30 est métallique, solidaire de la platine. Il a la forme d'un doigt et est réalisé par moulage. Dans un autre mode de réalisation, le doigt pourrait être rapporté à la platine, en étant par exemple soudé.

L'élément 10 est associé au module. Il comprend un nez 11 métallique solidaire de l'embase 1c du module et une pièce de contact 50 qui est introduite dans une cavité borgne 11a du nez.

Le nez 11 est moulé, et fait saillie vers l'arrière à partir de l'embase 1c du module, latéralement à une ouverture 101 prévue dans l'embase pour le passage du connecteur 200.

La pièce de contact 50 est une pièce métallique, par exemple en bronze, ayant pour forme un U présentant une âme 51, des ailes 52, des zones d'étranglement élastiques 53 et des cambrages 54.

L'âme 51 s'appuie sur l'embase 1c du boîtier du module, cette embase étant reliée électriquement à un conducteur de masse du cicuit imprimé du module, et se trouvant donc au même potentiel que ce dernier.

Chaque aile 52 présente une zone d'étranglement élastique 53, et à son extrémité supérieure un cambrage 54.

Lorsque la pièce de contact est introduite dans le nez, elle est maintenue grâce à des languettes 51a situées sur le dessous de l'âme qui sont enfilées dans des évidements appropriés de l'embase 1c puis écartées.

En variante, l'âme 51 peut être rivetée à l'embase 1c du module.

La pièce de contact joue le rôle de liaison de masse. Elle permet en effet de relier électriquement le circuit imprimé du module à la platine, l'âme 51 s'appuyant sur l'embase du module reliée électriquement au circuit imprimé et le doigt de la platine étant en contact avec les zones d'étranglement 53. Ces zones d'étranglement permettent en outre de maintenir le doigt coincé dans le nez.

Le module se monte sur le support 3 de la manière suivante.

Le module est déplacé selon une translation d'axe parallèle à l'axe longitudinal du doigt du support. Ainsi le nez vient s'enficher sur le doigt du support en traversant l'ouverture 20 du circuit de liaison. L'approche du module vers le support peut aussi s'effectuer par pivotement du module.

L'association de l'élément de connexion mâle à l'élément de connexion femelle est réalisée de façon à maintenir établie la liaison de masse lors de la connexion du circuit imprimé du module au circuit imprimé de liaison pendant les opérations de montage et de démontage. Ainsi les longeurs du nez, du doigt et la position des connecteurs sont déterminées de façon que le contact électrique entre la pièce métallique 50 et le doigt 30 soit établi en premier lors de la connexion du module au circuit imprimé de liaison, et interrompu en dernier lors de la déconnexion.

Dans une variante du mode de réalisation décrit ci-dessus, le nez peut être intérieur au module, et le doigt est alors d'une plus grande longueur.

Dans un autre mode de réalisation, on peut envisager d'associer l'élément mâle au module, et l'élément femelle au support.

Le dispositif 4 selon l'invention permet donc une continuité de masse, et permet aussi de fixer le module au support sans l'utilisation de moyens de fixation tels que des vis.

## Revendications

1. Appareil d'automatisation comprenant un dispositif de connexion de masse, notamment de liaison de terre, et au moins un module d'interface amovible (M) renfermant dans un boîtier (1) une électronique de traitement implantée sur au moins un circuit imprimé pouvant être relié électriquement à un circuit imprimé de liaison (2), porté par un support (3), par des connecteurs respectifs (100,200), le boîtier (1) pouvant être fixé au support (3) et relié électriquement à une partie conductrice de celui-ci par un dispositif de mise à la masse qui présente des éléments de connexion solidaires du support et du module, de manière à assurer un contact électrique mutuel entre le module (1) et le support (3), caractérisé en ce que
- les éléments de connexion comportent un élément mâle (30) et un élément femelle (10) coopérants par enfichage et
- le circuit imprimé de liaison (2) comprend une ouverture (20) traversée de manière isolée, dans la position montée du module, par l'un au moins des éléments de connexion.

2. Appareil d'automatisation selon la revendication 1, caractérisé en ce que l'élément de connexion femelle comprend une pièce métallique élastique (50) logée dans une cavité borgne d'un nez métallique rigide (11).

3. Appareil d'automatisation selon la revendication 1, caractérisé en ce que le boîtier du module comprend une paroi arrière métallique (1c) et que l'élément de connexion solidaire du module (1) vient de moulage avec la paroi arrière métallique.

4. Appareil d'automatisation selon la revendication 1, caractérisé en ce que l'élément de connexion solidaire du support (3) est un doigt venant de moulage avec le support.

5. Appareil d'automatisation selon la revendication 1, caractérisé en ce que les distances mutuelles entre les parties actives des éléments de connexion de masse (10,30) et les éléments de connexion des connecteurs (100,200) sont telles que la liaison de masse soit établie en premier lors de la connexion des circuits imprimés du module au circuit imprimé de liaison et interrompue en demier lors de leur déconnexion.

## Patentansprüche

1. Automatisierungsgerät mit einer Masseanschluß-Vorrichtung, insbesondere einer Erdungs-Vorrichtung, und mindestens einem umsetzbaren Schnittstellenmodul (M), das in einem Gehäuse (1) eine Verarbeitungselektronik beinhaltet, die auf mindestens einer gedruckten Schaltung installiert ist, die mittels jeweiligen Steckern (100, 200) elektrisch an eine gedruckte Verbindungsschaltung (2) angeschlossen werden kann, die von einem Träger (3) getragen wird, wobei das Gehäuse (1) am Träger (3) befestigt und über eine Masseanschluß-Vorrichtung elektrisch mit einem leitenden Teil desselben verbunden werden kann, wobei die Vorrichtung am Träger und am Modul befestigte Anschlußelemente aufweist, um einen elektrischen Kontakt zwischen dem Modul (1) und dem Träger (3) herzustellen, dadurch gekennzeichnet, daß
- die Anschlußelemente ein Steckerelement (30) und ein Steckdosenelement (10) umfassen, die zusammengesteckt werden, und
- die gedruckte Verbindungsschaltung (2) eine Öffnung (20) aufweist, die in montierter Position des Moduls isoliert von mindestens einem der Anschlußelemente durchquert wird.

2. Automatisierungsgerät nach Anspruch 1, dadurch gekennzeichnet, daß das Steckdosen-Anschlußelement ein federndes Metallteil (50) umfaßt, das in einem Blindloch einer starren Metallnase (11) angeordnet ist.

3. Automatisierungsgerät nach Anspruch 1, dadurch gekennzeichnet, daß das Gehäuse des Moduls eine hintere Metallwand (1c) umfaßt, und daß das am Modul (1) befestigte Anschlußelement an der hinteren Metallwand angeformt ist.

4. Automatisierungsgerät nach Anspruch 1, dadurch gekennzeichnet, daß das am Träger (3) befestigte Anschlußelement ein am Träger angeformter Finger ist.

5. Automatisierungsgerät nach Anspruch 1, dadurch gekennzeichnet, daß die gegenseitigen Abstände zwischen den aktiven Teilen der Masseanschlußelemente (10, 30) und den Anschlußelementen der Stecker (100, 200) so beschaffen sind, daß die Masseverbindung zuerst hergestellt wird, wenn die gedruckten Schaltungen des Moduls an die gedruckte Verbindungsschaltung angeschlossen werden, und zuletzt unterbrochen wird, wenn sie abgeschaltet werden.

## Claims

1. Automation equipment comprising a ground connection device, particularly earthing connection, and at least one removable interface module (M) consisting of a housing (1) enclosing processing electronics located on at least one printed circuit that can be electrically connected to a connecting printed circuit (2) fixed on a support (3) by connectors (100, 200), the housing (1) can be fixed to the support (3) and electrically connected to a conducting part of this board by a grounding device that has connection elements rigidly fixed to the support and the module, in order to provide mutual electric contact between the module (1) and the support (3), characterized in that
- the connection elements comprise a male element (30) and a female element (10) that plug into each other and
- the connecting printed circuit (2) comprises an opening (20) through which at least one of the connecting elements passes through, insulated, in the mounted position of the module.

2. Automation equipment according to claim 1, characterized in that the female connection element comprises an elastic metal part (50) housed in a blind cavity of a rigid metallic nose (11).

3. Automation equipment according to claim 1, characterized in that the module housing comprises a rear metallic wall (1c) and that the connection element rigidly attached to the module (1) is molded with the metallic rear wall.

4. Automation equipment according to claim 1, characterized in that the connection element fixed to support (3) is a pin molded with the support.

5. Automation equipment according to claim 1, characterized in that the mutual distances between the active parts of the ground connection elements (10, 30) and the connector connection elements (100, 200) are such that the ground link is established first when the module printed circuits are connected to the connection printed circuit and are broken last when they are disconnected.
